**Europäisches Patentamt**

(19) **European Patent Office**

**Office européen des brevets**

(11) Veröffentlichungsnummer: **0 068 392**
**B1**

(12) **EUROPÄISCHE PATENTSCHRIFT**

(45) Veröffentlichungstag der Patentschrift:
**20.11.86**

(51) Int. Cl.⁴: **H 01 L 29/91**, H 01 L 21/00

(21) Anmeldenummer: **82105432.7**

(22) Anmeldetag: **21.06.82**

(54) **Verfahren zur Herstellung von Schottky-Dioden.**

(30) Priorität: **23.06.81 DE 3124572**

(43) Veröffentlichungstag der Anmeldung:
**05.01.83 Patentblatt 83/1**

(45) Bekanntmachung des Hinweises auf die Patenterteilung:
**20.11.86 Patentblatt 86/47**

(84) Benannte Vertragsstaaten:
**DE FR GB IT**

(56) Entgegenhaltungen:
**EP - A - 0 012 220**

**NEUES AUS DER TECHNIK, Nr. 1, 1. Februar 1972, Seite 1, Würzburg, DE., "Herstellung von Halbleiter-Bauelementen mit schmalen Halbleiterzonen oder mit Halbleiterzonen in kleinem Abstand"
IBM TECHNICAL DISCLOSURE BULLETIN, Band 21, Nr. 5, Oktober 1978, Seite 1959, New York, USA, K.D. BEYER: "Formation of SBD guard rings"**

(73) Patentinhaber: **Siemens Aktiengesellschaft Berlin und München, Wittelsbacherplatz 2, D-8000 München 2 (DE)**

(72) Erfinder: **Müller, Jörg, Dr., Herzog-Tassilo-Ring 44, D-8011 Zorneding (DE)**

## Beschreibung

Die Erfindung betrifft ein Verfahren zur Herstellung von Schottky-Dioden, die im Randbereich des Schottky-Kontakts in der darunterliegenden Halbleiterschicht einen dotierten selbstjustierend angebrachten Schutzring aufweisen.

Bei der Herstellung von sehr kleinflächigen Schottky-Dioden, das heisst von Schottky-Dioden mit einem Durchmesser der Grössenordnung 10 µm, bereitet die Beseitigung der Randeffekte erhebliche Schwierigkeiten. Randeffekte bewirken z.B. eine schlechte Idealität, d.h. eine starke Abweichung von der theoretischen Kennlinie, ausserdem einen hohen Sperrstrom und einen weichen Durchbruch. Bei grossflächigen Schottky-Dioden lassen sich die unerwünschten Randeffekte durch einen mittels einer Photomaske eingebrachten Schutzring wesentlich verringern. Bei sehr kleinflächigen Schottky-Dioden stellt jedoch ein mittels Photomasken hergestellter Schutzring eine so erhebliche zusätzliche Kapazität dar, dass diese Technik nicht angewendet werden kann.

Es wurde deshalb versucht, bei der Herstellung von sehr kleinflächigen Schottky-Dioden ohne Schutzring auszukommen und statt dessen die unerwünschten Randeffekte mittels aufwendiger Reinigungsmethoden zu verringern. Mit derartigen Methoden liessen sich jedoch hiernach gefertigte Schottky-Dioden nicht reproduzierbar herstellen, weshalb ein derartiges Verfahren unbrauchbar ist.

Auf der Tagung, International Electron Devices Meeting, Washington, DC, 8. bis 12. Dezember 1980, wurde in einem Vortrag, A very small Skottky Barrier Diode (SBD) with self-aligned gard ring for VLSI application, von Sang und Kim erwogen, einen Schutzring für Schottky-Dioden selbstjustierend einzudiffundieren. Durch eine selbstjustierende Maskierung lassen sich zwar die Dimensionen für Schutzringe bei kleinen Schottky-Dioden herabsetzen, so dass die durch den Schutzring bedingte zusätzliche Kapazität auf ein erträgliches Ausmass herabgesetzt werden kann. Die Anwendung einer Diffusion bewirkt jedoch Nachteile für kleinflächige, hiernach gefertigte Schottky-Dioden. Die Anwendung einer Diffusion bewirkt eine Einschränkung in der Auswahl der anwendbaren Schottky-Metalle und wegen Ausdiffusionen während des Diffusionsprozesses eine Verschlechterung des Serienwiderstandes hiernach gefertigter Bauelemente. Wegen der sehr geringen Konzentration des Dotierstoffes beim Eindiffundieren derartiger Schutzringe ist es nicht möglich, aus der Gasphase zu dotieren. Es ist vielmehr der erhebliche Aufwand einer Diffusion aus der Amplitude notwendig. Trotz dieses erheblichen Aufwandes ist dennoch die Reproduzierbarkeit hiernach gefertigter Schottky-Dioden nicht in ausreichendem Masse gegeben.

Aus der EP-A-0 021 869 ist ein Verfahren zur Herstellung von Schottky-Dioden bekannt, bei dem im Randbereich des Schottky-Kontaktes in der darunterliegenden Halbleiterschicht durch Ionenimplantation mit Hilfe einer Implantationsmaske ein dotierter Schutzring in justierender Weise eingebracht wird. Eine mit einem justierenden Verfahren hergestellte Struktur ist bei gleichem Herstellungsaufwand immer um einen Faktor 2 schlechter ausgeführt als dieselbe mit einem selbstjustierenden Verfahren hergestellte Struktur. Bei dem aus dieser Veröffentlichung bekannten Verfahren werden insgesamt zwei Fototechnikschritte durchgeführt. Dies hat eine Vergrösserung der Schutzringbreite zur Folge, weil bei einem solchen bekannten Verfahren, bei dem zweimal justiert wird, die Schutzringbreite mindestens doppelt so gross wie die grösste Justiertoleranz sein muss. Dabei werden zu grosse parasitäre Kapazitäten des Schutzringes geschaffen, die für Hochfrequenzdioden nicht tragbar sind.

Aufgabe der Erfindung ist es daher, ein Verfahren der eingangs genannten Art anzugeben, das sowohl eine ausreichende Feinheit des Schutzringes, ein ausreichendes Mass an Reproduzierbarkeit und die Verwendbarkeit einer Vielzahl von Schottky-Metallen garantiert sowie während des Dotierungsverfahrens den Serienwiderstand des Bauelementes nicht verschlechtert.

Diese Aufgabe wird erfindungsgemäss durch ein Verfahren nach dem Anspruch 1 gelöst.

Bei selbstjustierend hergestellten Strukturen treten weniger Kanten, Ecken, Löcher und Oxidspalte auf als bei justierend hergestellten Strukturen. Da solche Ecken, Kanten, Löcher und Oxidspalte die Diffusion von Verunreinigungen begünstigen, ist ein Schottky-Kontakt mit einem selbstjustierend hergestellten Schutzring besonders vorteilhaft.

Die Verwendung einer Implantation anstelle einer Diffusion aus der Ampulle hat den Vorteil, dass eine bessere Reproduzierbarkeit hiernach gefertigter Bauelemente erreicht wird und dass zur Herstellung derartiger Bauelemente die Auswahl der hierzu verwendeten Schottky-Metalle nicht eingeschränkt wird. Ausserdem wird durch die Implantation der Serienwiderstand hiernach gefertigter Schottky-Dioden nicht beeinträchtigt, während im Falle der Diffusion der Serienwiderstand verschlechtert wird, was hervorgerufen wird durch die Ausdiffusion vorher in den Kristall eingebrachter Dotierungen. Die erfindungsgemässe Wahl der Implantationsmaske bestehend aus zwei Zwischenschichten von im allgemeinen unterschiedlichem Material bewirkt eine sehr günstige und einfache weitere Herstellung von hiernach gefertigten Schottky-Dioden, da Kontakte so angebracht werden können, dass durch den implantierten Schutzring die Geometrie der Schottky-Diode nicht wesentlich aufgeweitet wird und die erste Zwischenschicht auf der Halbleiteroberfläche belassen werden kann, wenn sie für das zu fertigende Bauelement gleichzeitig als Isolator wirkt.

Bei der Herstellung von kleinflächigen Schottky-Dioden ist es besonders vorteilhaft, dass die Breite des Schutzringes kleiner als 2 µm, insbesondere kleiner oder gleich ca. 1 µm ist. Unter der Breite eines Schutzringes wird bei Schottky-Dioden mit Kreissymmetrie an der äusseren Halbleiteroberfläche die Differenz zwischen inneren und dem äusseren Schutzringradius verstanden.

Damit kann die durch den Schutzring erzeugte Zusatzkapazität entsprechend klein gehalten werden, und es können zugleich alle Vorteile des Schutzringes erreicht werden.

Es ist erfinderisch, dass die erste Zwischenschicht aus ätzbarem Isolationsmaterial z.B. aus Siliciumdioxid von einer Schichtstärke von 0,3 μm bis 2 μm, insbesondere von 1 μm besteht. Dadurch können gezielte Unterätzungen zur Herstellung besonders feinstrukturierter Implantationsmasken verwendet werden.

Zur Erzeugung von Schottky-Dioden mit besonders dicker Isolationsschicht ist es besonders vorteilhaft, dass die erste Zwischenschicht mittels einer oder mehreren Schichten der Materialien Siliciumoxid (SiO), Siliciumdioxid ($SiO_2$), Siliciumnitrid ($Si_3N_4$) verstärkt wird. Es kann z.B. eine Schutzdiode mit einer dicken Isolatorschicht so hergestellt werden, dass eine 1 μm dünne, strukturierte erste Zwischenschicht aus Siliciumdioxid ($SiO_2$) mit einer dünnen z.B. 0,05 μm bis 0,2 μm starken Siliciumnitrid-Schicht ($Si_3N_4$) bedeckt und anschliessend mit einer z.B. 3 μm bis 10 μm starken Dickoxidschicht ($SiO_2$) versehen wird. Vorher geätzte Kanten der dünnen $SiO_2$-Schicht werden bei der nachfolgenden Dickoxidätzung mittels Flusssäure (HF) nicht angegriffen, da Siliziumnitrid von Flusssäure nicht angegriffen wird. Eine nachfolgende Nitridätzung mittels Phosphorsäure ($H_3PO_4$) greift wiederum Siliziumnitrid nicht an, so dass die Kanten der dünnen Siliziumdioxidschicht auch bei dieser Ätzung nicht angegriffen werden.

Es ist auch vorteilhaft, dass die zweite Zwischenschicht aus einem Metall z.B. einem Schottky-Metall besteht. Diese Massnahme hat nicht nur den Vorteil eines leichten Aufbringens bzw. Ätzens der zweiten Zwischenschicht. Es können vielmehr auch Temperaturschritte eingespart werden, die, infolge Ausdiffusion von im Halbleiter befindlichen Dotierungen, das Bauelement verschlechtern. Ausserdem kann durch eine geeignete Materialauswahl der zweiten Zwischenschicht, der Schottky-Kontakte und der Kontakte eine besonders günstige Kontaktgabe zwischen dem Halbleiter und den darauf angebrachten Kontakten erreicht werden.

Es ist auch vorteilhaft, dass zu Implantation Bor oder Phosphor verwendet werden, und dass das Substrat und die darauf befindliche Halbleiterschicht aus einem der Materialien Galliumarsenid (GaAs), Indiumphosphid (InP), Germanium (Ge) oder vorzugsweise Silicium bestehen.

Eine besonders günstige Ausgestaltung des erfindungsgemässen Verfahrens besteht darin, dass auf einem z.B. n+-dotierten Siliciumsubstrat eine z.B. n-dotierte Siliciumschicht epitaktisch abgeschieden wird, dass auf die äussere Oberfläche der epitaktisch abgeschiedenen Siliciumschicht eine erste Zwischenschicht, z.B. bestehend aus Siliciumdioxid, aufgebracht wird, dass mittels Fototechnik unter Verwendung einer Fotolackmaske Teile der Siliciumoberfläche so von Siliciumdioxid freigeätzt werden, dass unter der verbliebenen Fotolackmaske gezielt Unterätzungen entstehen, dass anschliessend eine ganzflächige Beschichtung mit Material der zweiten Zwischenschicht, z.B. bestehend aus Metall, erfolgt, dass anschliessend durch Abhebetechnik die Fotolackmaske mit den Teilen der darüber befindlichen zweiten Zwischenschicht abgehoben wird, dass anschliessend eine Ionenimplantation, angedeutet durch die Pfeile (10), in die durch die Unterätzung freigelegten Siliciumoberflächenteile erfolgt, so dass der Schutzring erzeugt wird, dass die Teile der zweiten Zwischenschicht von der Oberfläche (6) entfernt werden, dass anschliessend eine Aktivierung des implantierten Schutzringes erfolgt, dass schliesslich Schottky-Kontakte so angebracht werden, dass sie die von Siliciumdioxid ($SiO_2$) freien Halbleiteroberflächenteile so bedecken, dass mindestens der an den Schottky-Kontakt anschliessende Teilbereich des Schutzringes vom Schottky-Kontakt überdeckt wird.

Nachfolgend wird die Erfindung anhand der Zeichnung und an Ausführungsbeispielen näher erläutert. Es zeigen:

Fig. 1 eine Halbleiterscheibe mit Fotolackmaske und Unterätzungen in der ersten Zwischenschicht,

Fig. 2 eine Halbleiterscheibe nach Fig. 1 mit einer darauf abgeschiedenen zweiten Zwischenschicht,

Fig. 3 eine Halbleiterscheibe mit Implantationsmaske,

Fig. 4 eine Schottky-Diode mit implantiertem Schutzring,

Fig. 5 eine Schottky-Diode von kleiner Kapazität mit implantiertem Schutzring,

Fig. 6 eine Schottky-Diode mit Beam-Lead-Kontakten und implantiertem Schutzring.

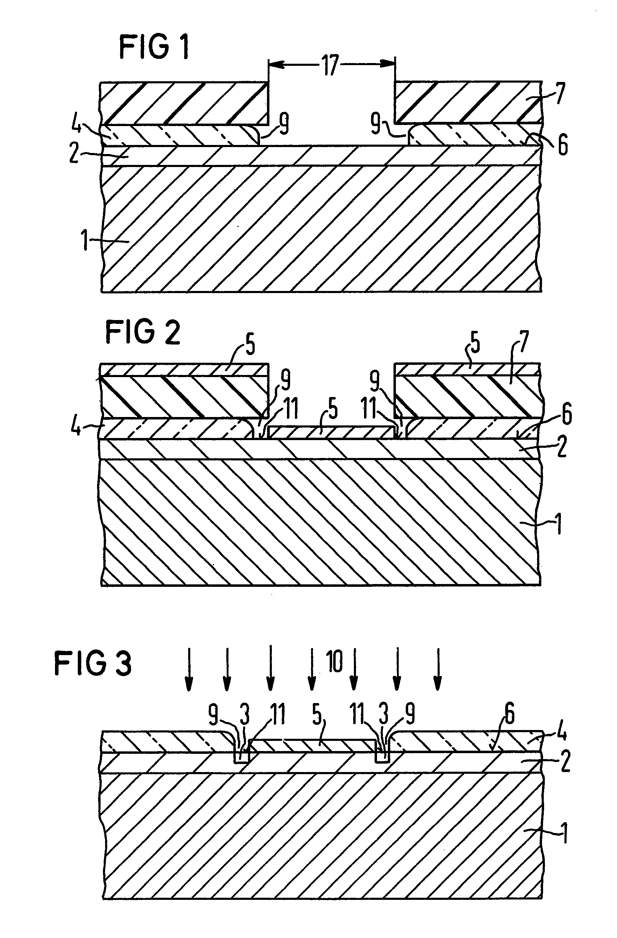

Fig. 1 zeigt ein Substrat 1, das gewöhnlich aus Halbleitermaterial besteht, mit einer Halbleiterschicht 2, die epitaktisch darauf abgeschieden ist. Auf der epitaktisch abgeschiedenen Halbleiterschicht 2 ist eine erste Zwischenschicht 4 angebracht, die von einer Fotolackmaske 7 überdeckt ist. In den Lücken 17 der Fotolackmaske 7 ist die darunterliegende erste Zwischenschicht 4 bis zur äusseren Oberfläche 6 der epitaktisch abgeschiedenen Halbleiterschicht 2 abgeätzt. An den Kanten der Fotolackmaske 7 innerhalb der Lücken 17, sind in der darunterliegenden ersten Zwischenschicht 4 gezielt Unterätzungen 9 angebracht. Das Substrat kann beispielsweise aus n+-dotiertem Silicium bestehen, während die Halbleiterschicht 2 aus n-dotiertem Silicium bestehen kann. Diese Materialwahl ist jedoch nicht zwingend. Substrat 1 und Halbleiterschicht 2 können auch die spiegelbildliche p-Dotierung aufweisen oder aus anderem Halbleitermaterial wie z.B. Germanium (Ge), Gallium-Arsenid (GaAs) oder Indium-Phosphid (InP) bestehen. Die erste Zwischenschicht 4 kann aus einem beliebigen Isolator, insbesondere aus Siliciumdioxid ($SiO_2$) bestehen.

In den folgenden Figuren sind gleiche Gegenstände wie in Fig. 1 beschrieben, mit gleichen Bezugszeichen belegt und werden deshalb nicht nochmals erläutert.

Fig. 2 zeigt eine Halbleiterscheibe nach Fig. 1 bei der auf der Fotolackmaske 7 und in den Lücken 17 der Fotolackmaske 7 ganzflächig eine zweite Zwischenschicht 5 abgeschieden ist. Die zweite Zwischenschicht 5 kann z.B. aus Metall, insbesondere aus einem Schottky-Metall bestehen. Infolge der Unterätzungen 9 bleiben bei der ganzflächigen Beschichtung durch die zweite Zwischenschicht 5 Oberflächenteile 11 der Halbleiterschicht 2 sowohl von der ersten Zwischenschicht 4 wie von der zweiten Zwischenschicht 5 frei.

Fig. 3 zeigt eine Halbleiterschicht wie Fig. 2, bei der die Fotolackmaske 7 mit Teilen der darüber befindlichen zweiten Zwischenschicht 5, z.B. mit Abhebetechnik entfernt ist. Es verbleibt dadurch eine Implantationsmaske für den Schutzring 3, gebildet aus Teilen der ersten Zwischenschicht 4 und der zweiten Zwischenschicht 5. Die Implantation ist angedeutet durch die Pfeile 10. Zur Implantation können z.B. Bor oder Phosphor verwendet werden. Im Falle eines n+-dotierten Substrats 1 und einer n-dotierten epitaktisch abgeschiedenen Halbleiterschicht 2 weist der Schutzring 3 eine p-Dotierung z.B. hervorgerufen mittels Bor-Implantation auf.

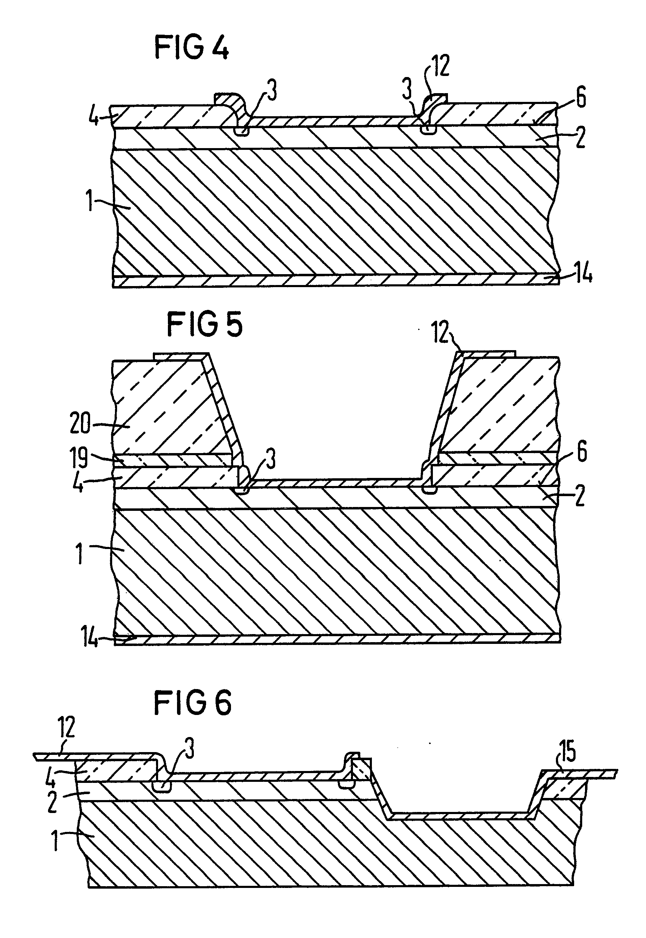

Fig. 4 stellt eine Halbleiterscheibe wie Fig. 3 dar, bei der die verbliebenen Teile der zweiten Zwischenschicht 5 entfernt wurden und an deren Stelle Schottky-Kontakte 12 angebracht wurden. Ausserdem sind Rückseitenkontakte 14 in Form einer Substratmetallisierung angebracht. Der Schottky-Kontakt 12 ist so angebracht, dass er sowohl die Halbleiterschicht 2 innerhalb des Schutzringes 3 kontaktiert sowie den ersten an diesen Bereich angrenzenden p-n-Übergang zwischen Schutzring und Halbleiterschicht 2 überlagert, während der zweite, der äussere p-n-Übergang zwischen Schutzring 3 und Halbleiterschicht 2 von der ersten Zwischenschicht 4, einer Isolatorschicht, überdeckt wird. Der Schottky-Kontakt 12 wird in der Regel von einer oder mehreren Metallschichten überlagert, wodurch eine besonders günstige Kontaktierung erreicht wird. Diese weiteren Metallschichten des Schottky-Kontakts 12 sind jedoch in den Figuren 4 bis 6 nicht dargestellt.

Fig. 5 unterscheidet sich von Fig. 4 dadurch, dass die erste Zwischenschicht 4 mittels zweier weiterer Schichten verstärkt ist. Und zwar befindet sich auf der Oberfläche 6 der Halbleiterschicht 2 als Zwischenschicht 4 eine 0,3 µm bis 2 µm, insbesondere 1 µm starke Siliciumdioxidschicht ($SiO_2$), darüber eine 0,05 µm bis 0,2 µm starke Siliciumnitridschicht 19 ($Si_3N_4$) und darüber wiederum eine ca. 3 µm bis 10 µm starke Dickoxidschicht 20, bestehend aus Siliciumdioxid ($SiO_2$). Mit derartig dickschichtigen Isolatorschichten lassen sich Schottky-Dioden mit kleinen Kapazitäten herstellen.

Fig. 6 unterscheidet sich von Fig. 4 dadurch, dass zur Erzielung von Beam-Lead-Strukturen bei Schottky-Dioden anstelle eines Rückseitenkontaktes das Substrat mittels des Kontaktes 15 von der gleichen Oberfläche her kontaktiert ist, auf welcher auch der Schottky-Kontakt 12 angebracht ist. Um Beam-Lead-Strukturen zu realisieren, ist es ausserdem nötig, den Schottky-Kontakt 12 an einer Seite weit über die Zwischenschicht 4 hinaus zu verlängern. Auch bei Beam-Lead-Strukturen, wie in Fig. 6 dargestellt, kann die erste Zwischenschicht 4 mittels einer oder mehreren Isolatorschichten verstärkt sein, wie in Fig. 5 dargestellt. Beam-Lead Strukturen haben den Vorteil, dass auf ein Gehäuse verzichtet werden kann und dass die parasitären Kapazitäten und die parasitären Induktivitäten bei Beam-Lead-Schottky-Dioden kleiner sind als bei entsprechenden Schottky-Dioden anderer Bauart.

Zur Herstellung einer erfindungsgemässen Schottky-Diode wird auf einem z.B. n-dotierten Siliciumsubstrat 1 eine n+-dotierte Siliciumschicht 2 epitaktisch abgeschieden, auf die äussere Oberfläche 6 der epitaktisch abgeschiedenen Siliciumschicht 2 wird eine erste Zwischenschicht 4, z.B. bestehend aus Siliciumdioxid ($SiO_2$) in einer Schichtdicke von 0,3 µm bis 2 µm, insbesondere 1 µm, aufgebracht. Mittels einer darüber abgeschiedenen Fotolackmaske 7 werden die Strukturen der Schottky-Dioden beispielsweise von einem Durchmesser von 3 µm bis 20 µm durch die Siliciumdioxidschicht bis zur Halbleiteroberfläche 6 der epitaktisch abgeschiedenen Schicht 2 durchgeätzt. Bei einer derartigen Ätzung entstehen in der Siliciumdioxidschicht Unterätzungen von ca. 1 µm gemessen vom Rand der Fotolackmaske hin zur Siliciumdioxidbegrenzung auf der Halbleiteroberfläche. Anschliessend wird eine ganzflächige Bedampfung der Halbleiterscheibe mit einer zweiten Zwischenschicht 5 z.B. bestehend aus Metall, insbesondere Schottky-Metall, vorgenommen. Dabei entstehen Metallablagerungen sowohl auf der Fotolackmaske wie auch auf der Halbleiteroberfläche in den Lücken der Fotomaske 7. Innerhalb der Unterätzungen 9 bleibt die Halbleiteroberfläche 6 jedoch von der Metallschicht wie auch von der Siliciumdioxidschicht frei. Nachfolgend wird die Fotomaske 7 sowie die darauf befindliche Metallschicht z.B. mittels Abhebetechnik von der Scheibenoberfläche entfernt. Auf der Halbleiterscheibe verbleibt somit eine Maske bestehend aus Teilen der aufgedampften Metallschicht sowie aus Siliciumdioxidteilen, wobei beide Maskenteile Lücken von ca. 1 µm gegeneinander aufweisen, die durch die gezielte Unterätzung entstanden sind. Danach wird die Scheibe einer Ionenimplantation ausgesetzt, so dass die Schutzringdotierung unterhalb der Unterätzungslücken entsteht. Bei n+-dotiertem Siliciumsubstrat 1 und n-dotierter epitaktisch abgeschiedener Halbleiterschicht erhält der Schutzring 3 eine p-Dotierung z.B. mittels Bor-Implantation. Anschliessend werden die verbliebenen Teile der Metallschicht entfernt. Nach einem Ausheilprozess und einer Aktivierung des Schutzringes 3 erfolgt bei Schottky-Dioden mit grösseren Kapazitäten unmittelbar anschliessend die Aufbringung der Schottky-Kontakte, während bei Schottky-Dioden mit kleinen Kapazitäten vor der Anbringung der Schottky-Dioden eine ganzflächige Beschichtung zunächst mit Siliciumnitrid ($Si_3N_4$) in einer Schichtdicke von 0,05 µm bis 2 µm, insbesondere 1 µm, und darauf wiederum die Abscheidung einer Siliciumdickoxidschicht, bestehend aus Siliciumdioxid ($SiO_2$) in einer Schichtdicke von ca. 3 µm bis 10 µm erfolgt. Auf der Siliciumdickoxidschicht wird anschliessend eine Fotomaske angebracht. Mit dieser Fotomaske und mit z.B. Flusssäure (HF) als Ätzmittel wird Dickoxid oberhalb des Schottky-Diodenbereichs bis zur Siliciumnitridschicht durchgeätzt. Nach Entfernen der Fotomaske wird die Siliciumnitridschicht mittels Phosphorsäure ($H_3PO_4$) und mit der Dickoxidschicht als Maske geätzt. Die Fotomaske bei der Dickoxidschicht wird dabei so gewählt, dass die sich ergebenden Öffnungen im Dickoxid sowie im Siliciumnitrid etwas weiter sind als die bereits vorhandene Öffnung der untersten dünnen Siliciumdioxidschicht. Nachfolgend erfolgt auch in diesem Falle das Anbringen des Schottky-Kontaktes. Der Schottky-Kontakt ist dabei so angebracht, dass er den inneren, der Schottky-Diode zugewandten p-n-Übergang zwischen dem Schutzring und der Halbleiterschicht überlagert, während der äussere p-n-Übergang zwischen Schutzring und Halbleiterschicht von der dünnen Siliciumdioxidschicht überlagert wird. Die Schottky-Metallkontakte werden schliesslich noch mit weiteren Metallschichten überzogen, um besonders günstige Kontakte zu erzeugen. Die Substratkontaktierung erfolgt entweder als ganzflächige Rückseitenkontaktierung oder z.B. im Falle von Beam-Lead-Strukturen durch versenkte Kontakte, die von der gleichen Halbleiteroberfläche her angebracht sind wie die Schottky-Kontakte.

Die Erfindung eignet sich zur Erzeugung von beliebigen Schottky-Dioden, insbesondere zur Herstellung von Mikrowellen-Schottky-Dioden.

**Patentansprüche**

1. Verfahren zur Herstellung von Schottky-Dioden, die im Randbereich des Schottky-Kontaktes in der darunterliegenden Halbleiterschicht einen dotierten selbstjustierend angebrachten Schutzring aufweisen, dadurch gekennzeichnet, dass auf der Halbleiterschicht eine erste Zwischenschicht angebracht wird, die mittels Fototechnik unter Verwendung einer Fotolackmaske so strukturiert wird, dass unter der verbliebenen Fotolackmaske gezielt Unterätzungen entstehen, dass eine zweite Zwischenschicht ganzflächig in der Weise aufgebracht wird, dass die Halbleiterschicht innerhalb der Unterätzungen von der zweiten Zwischenschicht frei bleibt, dass die Fotolackmaske mit den Teilen der darüber befindlichen zweiten Zwischenschicht entfernt wird und dass der Schutzring mittels Implantation in die durch die Unterätzung freigelegte Halbleiterschicht eingebracht wird.

2. Verfahren nach Anspruch 1, dadurch gekennzeichnet, dass die Breite des Schutzringes (3) kleiner als 2 µm, insbesondere kleiner oder gleich ca. 1 µm ist.

3. Verfahren nach einem der Ansprüche 1 oder 2, dadurch gekennzeichnet, dass die erste Zwischenschicht (4) aus ätzbarem Isolatormaterial besteht.

4. Verfahren nach einem der Ansprüche 1 bis 3, dadurch gekennzeichnet, dass die erste Zwischenschicht (4) aus einer 0,3 µm bis 2 µm, insbesondere 1 µm starken Siliciumdioxidschicht ($SiO_2$) besteht.

5. Verfahren nach einem der Ansprüche 1 bis 4, dadurch gekennzeichnet, dass die erste Zwischenschicht (4) mittels einer oder mehreren Schichten der Materialien Siliciumoxid (SiO), Siliciumdioxid ($SiO_2$), Siliciumnitrid ($Si_3N_4$) verstärkt wird.

6. Verfahren nach einem der Ansprüche 1 bis 5, dadurch gekennzeichnet, dass die zweite Zwischenschicht (5) aus einem Metall, insbesondere aus einem Schottky-Metall besteht.

7. Verfahren nach einem der Ansprüche 1 bis 6, dadurch gekennzeichnet, dass zur Implantation Bor oder Phosphor verwendet werden.

8. Verfahren nach einem der Ansprüche 1 bis 7, dadurch gekennzeichnet, dass das Substrat (1) und die Halbleiterschicht (2) aus einem der Materialien Galliumarsenid (GaAr), Indiumphosphid (InP), Germanium (Ge) oder vorzugsweise Silicium (Si) bestehen.

9. Verfahren nach einem der Ansprüche 1 bis 8, gekennzeichnet durch folgende nacheinander auszuführende Verfahrensschritte:

Auf einem Siliciumsubstrat (1) wird eine dotierte Siliciumschicht (2) epitaktisch abgeschieden;

auf die äussere Oberfläche (6) der epitaktisch abgeschiedenen Halbleiterschicht (2) wird eine erste Zwischenschicht (4) bestehend aus Siliciumdioxid ($SiO_2$) aufgebracht;

mittels Fototechnik unter Verwendung einer Fotolackmaske (7) werden Teile (11) der Siliciumoberfläche (6) so von Siliciumdioxid freigeätzt, dass unter der verbliebenen Fotolackmaske (7) gezielt Unterätzungen (9) entstehen;

es erfolgt eine ganzflächige Beschichtung mit Material einer zweiten Zwischenschicht (5) in der Weise, dass die Siliciumoberfläche innerhalb der Unterätzungen von der Metallschicht frei bleibt;

die Fotolackmaske (7) wird mit den Teilen der darüber befindlichen zweiten Zwischenschicht (5) entfernt;

mittels einer Ionenimplantation (10) in die durch die Unterätzung (9) freigelegten Siliciumoberflächenteile (11) wird der Schutzring (3) erzeugt;

der auf der freigeätzten Siliciumoberfläche verbliebene Teil der zweiten Zwischenschicht (5) wird entfernt;

der Schottky-Kontakt wird so angebracht, dass er den inneren, der Schottky-Diode zugewandten p-n-Übergang zwischen dem Schutzring und der Siliciumschicht überlagert, während der äussere p-n-Übergang zwischen Schutzring und Halbleiterschicht von einer dünnen Siliciumdioxidschicht überlagert wird.

**Claims**

1. A method of manufacturing Schottky diodes which, in the edge zone of the Schottky contact, contain in the underlying semiconductor layer a doped protective ring arranged to be self-adjusting, characterised in that a first intermediate layer is applied to the semiconductor layer and is structured by a photo-technique using a photo-lacquer mask in such a way that controlled under-etchings are formed beneath the residual photo-lacquer mask; that a second intermediate layer is applied to the entire surface in such a way that within the under-etchings, the semiconductor layer remains free from the second intermediate layer; that the photo-lacquer mask is removed, together with the overlying parts of the second intermediate layer; and that the protective ring is introduced by implantation into the semiconductor layer which has been exposed by the under-etching.

2. A method as claimed in Claim 1, characterised in that the width of the protective ring (3) is less than 2 μm, particularly but not exclusively less than or equel to about 1 μm.

3. A method as claimed in one of Claims 1 and 2, characterised in that the first intermediate layer (4) consists of etchable insulating material.

4. A method as claimed in one of Claims 1 to 3, characterised in that the first intermediate layer (4) concists of a silicon dioxide layer ($SiO_2$) having a thickness of 0.3 μm to 2 μm, particularly but not exclusively 1 μm.

5. A method as claimed in one of Claims 1 to 4, characterised in that the first intermediate layer (4) is reinforced by one or more layers of the materials silicon oxide (SiO), silicon dioxide ($SiO_2$), silicon nitride ($Si_3N_4$).

6. A method as claimed in one of Claims 1 to 5, characterised in that the second intermediate layer (5) consists of a metal, particularly but not exclusively a Schottky metal.

7. A method as claimed in one of Claims 1 to 6, characterised in that boron or phosphoros is used for the implantation.

8. A method as claimed in one of Claims 1 to 7, characterised in that the substrate (1) and the semiconductor layer (2) consist of one of the materials gallium arsenide (GaAr), indium phosphide (InP), germanium (Ge) or preferably silicon (Si).

9. A method as claimed in one of Claims 1 to 8, characterised by the following process steps which are to be carried out consecutively:

a doped silicon layer (2) is epitaxially deposited on to a silicon substrate (1);

a first intermediate layer (4) consisting of silicon dioxide ($SiO_2$) is applied to the outer surface (6) of the epitaxially deposited semiconductor layer (2);

by a photo-technique using a photo-lacquer mask (7), parts (11) of the silicon surface (6) are etched free from silicon dioxide in such a way that controlled under-etchings (9) are purposively formed beneath the remaining photo-lacquer mask (7);

the entire surface is coated with material of a second intermediate layer (5) in such a way that the silicon surface beneath the under-etchings remains free from the metal layer;

the photo-lacquer mask (7) is removed, together with the overlying parts of the second intermediate layer (5);

the protective ring (3) is produced by ion implantation (1) into the parts of the silicon surface (11) which have been exposed by the under-etching (9);

the part of the second intermediate layer (5) which remains on the silicon surface which has been etched free is removed;

the Schottky contact is applied in such a way that it overlies the inner pn-junction which exists between the protective ring and the silicon layer and which faces towards the Schottky diode, whilst the outer pn-junction between the protective ring and the semiconductor layer is overlied by a thin silicon dioxide layer.

**Revendications**

1. Procédé pour fabriquer des diodes Schottky, qui comportent, dans la zone marginale du contact Schottky, dans la couche semiconductrice sous-jacente, un anneau de protection dopé, mis en place par auto-alignement, caractérisé par le fait qu'on dépose sur la couche semi-conductrice une première couche intermédiaire qui est structurée au moyen de la technique photosensible moyennant l'utilisation d'un masque de vernis photosensible de telle sorte qu'il apparaît, intentionnellement, des corrosions à sous-gravures au-dessous du masque de vernis photosensible subsistant, qu'on dépose une couche intermédiaire sur toute la surface de manière que la couche semi-conductrice située à l'intérieur des zones de corrosion à sous-gravures reste exempte de la seconde couche intermédiaire, qu'on enlève le masque de vernis photosensible comportant les parties de la seconde couche intermédiaire située au-dessus du masque et qu'on insère l'anneau de protection, au moyen d'une implantation, dans la couche semi-conductrice, mise à nu par la corrosion à sous-gravures.

2. Procédé suivant la revendication 1, caractérisé par le fait que la largeur de l'anneau de protection (3) est inférieure à 2 μm et notamment est inférieure ou égale à environ 1 μm.

3. Procédé suivant l'une des revendications 1 ou 2, caractérisé par le fait que la première couche intermédiaire (4) est constituée en un matériau isolant pouvant être corrodé.

4. Procédé suivant l'une des revendications 1 à 3, caractérisé par le fait que la première couche intermédiaire (4) est constituée par une couche de bioxyde de silicium ($SiO_2$) possédant une épaisseur comprise entre 0,3 μm et 2 μm et égale notamment à 1 μm.

5. Procédé suivant l'une des revendications 1 à 4, caractérisé par le fait que la première couche intermédiaire (4) est renforcée par une ou plusieurs couches des matériaux suivants: oxyde de silicium (SiO), bioxyde de silicium ($SiO_2$), nitrure de silicium ($Si_3N_4$).

6. Procédé suivant l'une des revendications 1 à 5, caractérisé par le fait que la seconde couche intermédiaire (5) est constituée en un métal, notamment en un métal fournissant l'effet Schottky.

7. Procédé suivant l'une des revendications 1 à 6, caractérisé par le fait qu'on utilise du bore ou du phosphore pour l'implantation.

8. Procédé suivant l'une des revendications 1 à 7, caractérisé par le fait que le substrat (1) et la couche semi-conductrice (2) sont constitués par l'un des matériaux suivants: arséniure de gallium (GaAs), phophure d'indium (InP), germanium (Ge) ou de préférence silicium (Si).

9. Procédé suivant l'une des revendications 1 à 8, caractérisé par les phases opératoires suivantes devant être exécutées successivement:
- on dépose par voie épitaxiale une couche de silicium dopé (2) sur un substrat en silicium (1);
- on dépose une première couche intermédiaire (4) constituée par du bioxyde de silicium (SiO$_2$) sur la surface extérieure (6) de la couche semi-conductrice (2) déposée par épitaxie;
- au moyen de la technique photosensible et moyennant l'utilisation d'un masque de vernis photosensible (7) on enlève par corrosion le silicium sur les parties (11) de la surface (6) du silicium de manière à obtenir, de façon voulue, des zones de corrosion à sous-gravures (9) au-dessous du masque de vernis photosensible (7) subsistant,
- on réalise un revêtement de l'ensemble de la surface avec un matériau d'une seconde couche intermédiaire (5) de manière que la surface du silicium à l'intérieur des zones de corrosion à sous-gravures reste exempte de la couche métallique;
- on élimine le masque de vernis photosensible (7) ainsi que les parties de la seconde couche intermédiaire (5) situées au-dessus du masque;
- à l'aide d'une implantation ionique (10) on réalise l'anneau de protection (3) dans les parties (11) de la surface du silicium, qui sont mises à nu par la zone de corrosion à sous-gravures (9);
- on élimine la partie de la seconde couche intermédiaire (5), qui subsiste au niveau de la surface du silicium mise à nu par corrosion;
- on dépose le contact de Schottky de manière qu'il soit superposé à la jonction intérieure p-n, tournée vers la diode Schottky, entre l'anneau de protection et la couche de silicium, tandis qu'on appose une couche mince de bioxyde de silicium sur la jonction extérieure p-n entre l'anneau de protection et la couche semi-conductrice.

**FIG 1**

**FIG 2**

**FIG 3**

## FIG 4

## FIG 5

## FIG 6